# EUROPEAN PATENT SPECIFICATION

(11) **EP 2 405 726 B1**
(45) Date of publication and mention of the grant of the patent: **23.10.2013**
(21) Application number: 11173152.7
(22) Date of filing: 07.07.2011
(51) Int. Cl.: H05K 3/36, H05K 3/42, H05K 3/46

(54) **Method for manufacturing a printed circuit board**
Verfahren zur Herstellung einer Leiterplatte
Procédé de fabrication de carte de circuit imprimé

(30) Priority: 07.07.2010 JP 2010155137
(43) Date of publication of application: 11.01.2012
(73) Proprietor: Kabushiki Kaisha Toshiba, Minato-ku, Tokyo 105-8001 (JP)
(72) Inventor: Kajio, Hiroshi, Minato-ku, Tokyo 105-8001 (JP)
(74) Representative: Granleese, Rhian Jane

(56) References cited:
- EP-A1- 1 098 558
- EP-A2- 2 076 106
- JP-A- 2001 189 559
- US-A1- 2001 039 727
- US-A1- 2009 094 824

## Description

### FIELD

Embodiments described herein relate generally to a method for manufacturing a printed circuit board.

### BACKGROUND

As a method for effectively preventing scattering of glass fiber chippings from a cut plane of a printed circuit board, the technique of plating the entire end face of the cut plane and the entire wall face of a through-hole is known.

However, in a case where part of a through-hole of a printed circuit board is plated, it is difficult to manufacture the printed circuit board with high precision by conventional manufacturing methods.

US 2009/094824, EP 1 098 558, US 2001/039727, JP 2001 189559 AND EP 2 076 106 all relate to methods of producing substrates or printed wiring boards with plated vias or through holes.

### BRIEF DESCRIPTION OF THE DRAWINGS

FIG. 1 shows an example of a first state in a method for manufacturing a printed circuit board according to an embodiment.
FIG. 2 shows an example of a second state in the method of FIG. 1.
FIG. 3 shows an example of a third state in the method of FIG. 1.
FIG. 4 shows an example of a fourth state in the method of FIG. 1.
FIG. 5 shows an example of a fifth state in the method of FIG. 1.
FIG. 6 shows an example of a sixth state in the method of FIG. 1.
FIG. 7 shows an example of a seventh state in the method of FIG. 1.
FIG. 8 is a schematic diagram showing how a first multilayer board having a via hole of FIG. 2 looks when viewed from the top surface side of the first multilayer board.
FIG. 9 is a schematic diagram showing how the first multilayer board subjected to plating of FIG. 3 looks when viewed from the top surface side of the first multilayer board.
FIG. 10 is a schematic diagram showing how a printed circuit board having a through-hole of FIG. 7 looks when viewed from the top surface side of the second multilayer board.
FIG. 11 shows an example of a first state in a manufacturing step of plating part of the through-hole of the printed circuit board.
FIG. 12 shows an example of a second state in the manufacturing step of FIG. 11.
FIG. 13 shows an example of a third state in the manufacturing step of FIG. 11.
FIG. 14 shows an example of a fourth state in the manufacturing step of FIG. 11.
FIG. 15 is a schematic diagram showing how the first multilayer board having the via hole of FIG. 2 looks when viewed from the top surface side of the first multilayer board.
FIG. 16 is a schematic diagram showing how the first multilayer board subjected to plating of FIG. 3 looks when viewed from the top surface side of the first multilayer board.
FIG. 17 is a schematic diagram showing how the printed circuit board having the through-hole of FIG. 7 looks when viewed from the top surface side of the second multilayer board.

### DETAILED DESCRIPTION

In general, according to one embodiment, a method for manufacturing a printed circuit board includes forming a via hole in a first multilayer board having a laminated structure comprising a metallic foil, a core board, and prepreg for interlayer connection, plating a wall surface of the via hole, filling a resin into the via hole, applying lid-plating to close the via hole filled with the resin, overlaying a second multilayer board on a surface of the first multilayer board, forming a through-hole passing from the first multilayer board to the second multilayer board in such a position that the through-hole is surrounded by a plated part of the wall surface, and removing the filled resin.

### [First Embodiment]

Referring to the drawings, an embodiment will be described below.

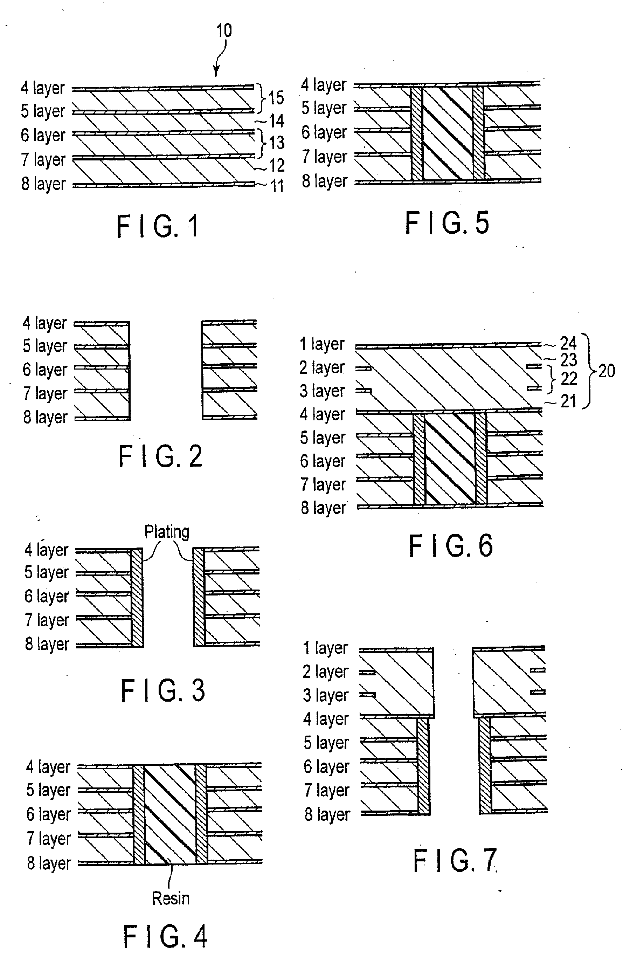

FIGS. 1-7 are schematic diagrams showing examples of the steps in a method for manufacturing a printed circuit board according to the present embodiment. Referring to FIGS. 1-7, a case of connecting by plating fourth to eighth layers of a printed circuit board having an eight-layer structure will be described.

First, as shown in FIG. 1, a first multilayer board 10 to be brought into conduction is manufactured. More specifically, core board 13, which is a circuit board, is overlaid on metallic foil 11, which is the eighth layer, via prepreg 12 for interlayer connection. Then, core board 15 is overlaid on core board 13 via prepreg 14.

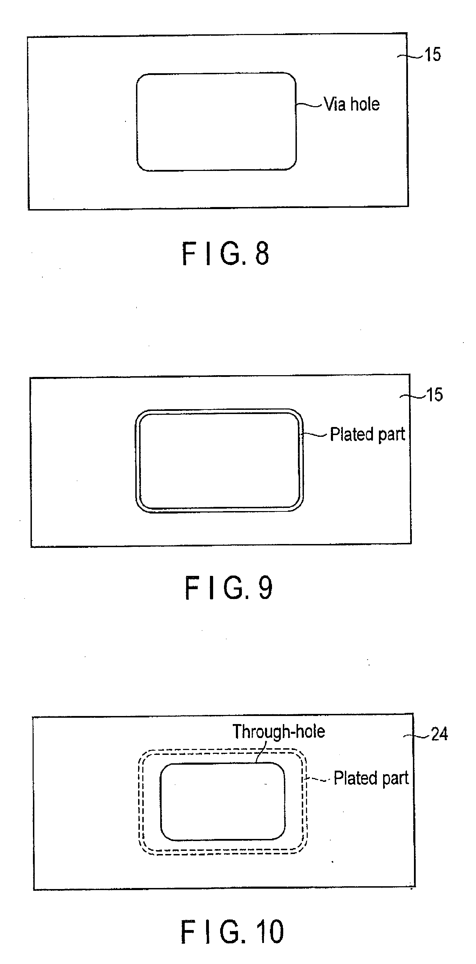

Next, as shown in FIG. 2, a via hole is formed in the first multilayer board 10. FIG. 8 is a schematic diagram showing how the first multilayer board 10 having the via hole of FIG. 2 looks when viewed from the top surface side of the first multilayer board 10.

Then, as shown in FIG. 3, an inner wall surface of the via hole is plated. FIG. 9 is a schematic diagram showing how the first multilayer board 10 subjected to plating of FIG. 3 looks when viewed from the top surface side of the first multilayer board 10.

Subsequently, as shown in FIG. 4, a resin is filled into the via hole.

Then, as shown in FIG. 5, lid-plating is applied to the both sides of the first multilayer board 10 to close the via hole filled with the resin.

After that, as shown in FIG. 6, the remaining layers are overlaid on the top surface of the first multilayer board 10. In the present embodiment, the remaining layers will be referred to as a second multilayer board 20 for the sake of explanation. The second multilayer board 20 is formed by overlaying, on the top surface of the first multilayer board 10, prepreg 21, core board 22, prepreg 23 and metallic foil 24.

Next, as shown in FIG. 7, a through-hole passing through the first and second multilayer boards 10, 20 is formed in such a position as to pass through the via hole formed in the first multilayer board 10. FIG. 10 is a schematic diagram showing how the printed circuit board having the through-hole of FIG. 7 looks when viewed from the top surface of the second multilayer board 20. As shown in FIG. 10, the through-hole is smaller than the via hole. The resin filled in the via hole is removed from the bottom surface of the first multilayer board 10.

As described above, in the present embodiment, the first multilayer board 10 is first manufactured, and then the inner surface of the via hole formed in the first multilayer board 10 is plated. After that, the remaining layers are formed on the first multilayer board 10, and the through-hole is formed so that the plated portion in the first multilayer board 10 surrounds the through-hole.

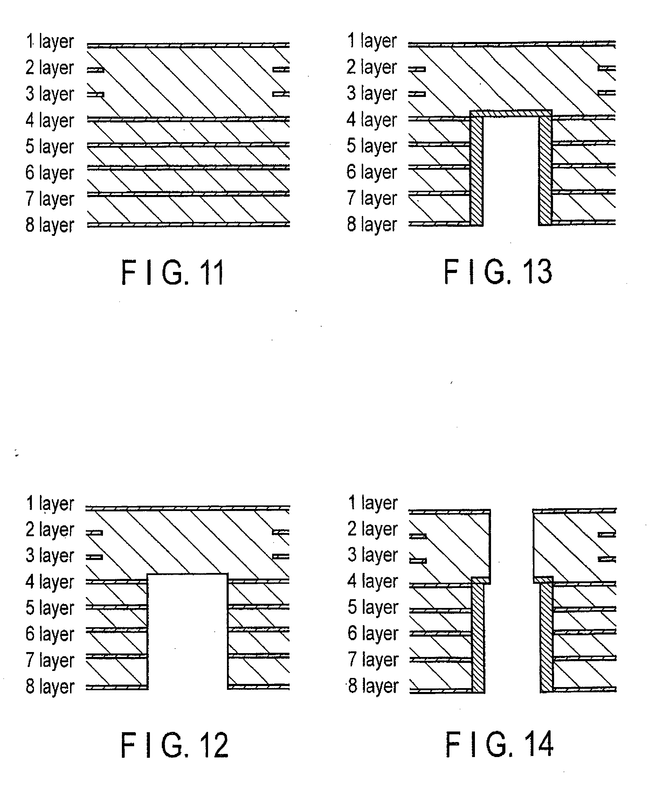

FIGS. 11-14 show a case of plating part of a through-hole in a printed circuit board by general manufacturing steps. Referring to FIGS. 11-14, a case of plating fourth to eighth layers of a printed circuit board having an eight-layer structure will be described.

First, as shown in FIG. 11, an eight-layer multilayer board is laminated by metallic foils, core boards and prepregs.

Next, as shown in FIG. 12, a hole is formed from the fourth layer to the eighth layer.

Then, as shown in FIG. 13, a wall surface of the hole shown in FIG. 12 is plated.

After that, as shown in FIG. 14, a through-hole is formed from the first layer to the eighth layer.

However, in the printed circuit board manufactured following the steps corresponding to FIGS. 11-14, a router reaches deeper than an inner layer desired to be brought into conduction, and plating reaches deeper than the inner layer desired to be brought into conduction. In such a case, even when precise impedance control is required between the first and fourth layers, desired impedance control cannot be realized because plating extends out to the third layer side.

For example, when the distance between the first layer and the fourth layer of a multilayer board is 0.56 mm, and the dielectric constant of the multilayer board is 3.85, the width of a microstripline needs to be 1.127 mm to make the characteristic impedance of the microstripline of the first layer 50Ω. If the distance between the first layer and the fourth layer is reduced to 0.5 mm by router processing, the characteristic impedance of the microstripline having the width of 1.127 mm is reduced to 46.6Ω, i.e., changes by no less than 6.8%.

In contrast, according to the manufacturing method of the present embodiment, plating between desired layers can be performed without causing the plating to extend out to another layer. Therefore, the degree of precision in impedance control is increased.

Accordingly, the manufacturing method of the present embodiment makes it possible to perform desired impedance control even when part of the through-hole is plated and thereby manufacture printed circuit boards with high precision.

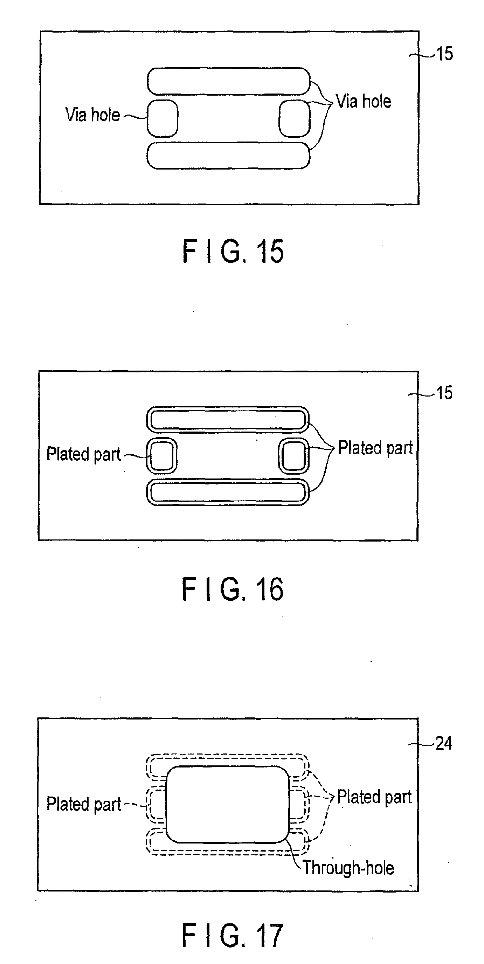

In the above-described embodiment, the case of plating part of the through-hole as shown in FIGS. 8-10 following the manufacturing method corresponding to FIGS. 1-7 has been described. However, the present embodiment is not limited to this case. For example, part of the through-hole may be plated as shown in FIGS. 15-17 following the manufacturing method corresponding to FIGS. 1-7. For example, in the step corresponding to FIG. 2, a plurality of via holes shown in FIG. 15 are formed. Those via holes are located in such a position that the through-hole formed in the step corresponding to FIG. 7 overlap part of each of the via holes, and part of each of the wall surfaces of the via holes not overlapping the through-hole forms part of the wall surface of the through-hole.

In the step corresponding to FIG. 3, each via hole is plated as shown in FIG. 16. Then, in the step corresponding to FIG. 7, a through-hole is formed as shown in FIG. 17. Accordingly, the part overlapping the through-hole of the plated part of each via hole is removed. Consequently, as in the step corresponding to FIG. 10, the wall surface of the through-hole in the first multilayer board 10 is plated.

As shown in FIG. 5, when a resin is filled into the via hole, and lid-plating is applied, the filled resin may contract after drying. In such a case, a uniform surface is not formed, and a problem, such as contact failure and exfoliation, may be caused in the steps subsequent to lid-plating. For example, when the via hole shown in FIG. 8 is formed, this kind of problem is often caused because a large volume of resin is filled. The volume of resin filled in one via hole can be reduced by increasing the number of via holes as shown in FIG. 15 and reducing the size of each via hole. This structure has the advantage that a problem, such as contact failure and exfoliation, is less caused.

In addition, the manufacturing method of the above-described embodiment does not require a special process. Therefore, the manufacturing method of the above-described embodiment can be employed together with a connection method, such as a through-hole, blind via hole (BVH), and interstitial via hole (IVH).

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A method for manufacturing a printed circuit board **characterized by** comprising:
forming a via hole in a first multilayer board (10) having a laminated structure comprising a metallic foil (11), a core board (13, 15), and prepreg (12, 14) for interlayer connection;
plating a wall surface of the via hole;
filling a resin into the via hole;
applying lid-plating to close the via hole filled with the resin;
overlaying a second multilayer board (20) on a surface of the first multilayer board (10);
forming a through-hole passing from the first multilayer board (10) to the second multilayer board (20) in such a position that the through-hole is surrounded by a plated part of the wall surface; and
removing the filled resin.

2. The method according to claim 1, **characterized in that**
the via hole is a single hole, and
the through-hole is smaller than the via hole.

3. The method according to claim 1, **characterized in that**
the via hole is a plurality of holes,
the holes overlap part of the through-hole, and are located in such a position that a part nonoverlapping the through-hole of a wall surface of each of the holes forms part of a wall surface of the through-hole, and
the through-hole is formed to remove part of each of the holes overlapping the through-hole.

## Patentansprüche

1. Verfahren zur Herstellung einer Leiterplatte, **dadurch gekennzeichnet, dass** es die folgenden Schritte aufweist:
Bilden eines Kontaktloches in einer ersten Mehrlagenleiterplatte (10) mit einer laminierten Struktur, die eine Metallfolie (11), eine Kernplatte (13, 15) und ein Prepreg (12, 14) für eine Zwischeniagenverbindung aufweist;
Galvanisieren einer Wandfläche des Kontaktloches;
Füllen eines Harzes in das Kontaktloch;
Aufbringen eines galvanischen Abdecküberzuges, um das mit dem Harz gefüllte Kontaktloch zu verschließen;
Darüberlegen einer zweiten Mehrlagenleiterplatte (20) auf eine Oberfläche der ersten Mehrlagenleiterplatte (10);
Ausbilden eines Durchgangsloches, das von der ersten Mehrlagenleiterplatte (10) zur zweiten Mehrlagenleiterplatte (20) verläuft, in einer derartigen Position, dass das Durchgangsloch durch einen galvanisierten Teil der Wandfläche umgeben wird; und
Entfernten des eingefüllten Harzes.

2. Verfahren nach Anspruch 1, **dadurch gekennzeichnet, dass**
das Kontaktloch ein einzelnes Loch ist, und
das Durchgangsloch kleiner ist als das Kontaktloch.

3. Verfahren nach Anspruch 1, **dadurch gekennzeichnet, dass**
das Kontaktloch eine Vielzahl von Löchern ist,
die Löcher einen Teil des Durchgangsloches überdecken und in einer derartigen Position angeordnet sind, dass ein Teil, der nicht das Durchgangsloch einer Wandfläche eines jeden der Löcher überdeckt, einen Teil einer Wandfläche des Durchgangsloches bildet, und
das Durchgangsloch ausgebildet ist, um einen Teil eines jeden der Löcher zu entfernen, die das Durchgangsloch überdecken.

## Revendications

1. Procédé pour fabriquer une carte de circuit imprimé **caractérisé en ce qu'**il comprend les étapes consistant à :
former un trou de raccordement dans une première carte multicouche (10) ayant une structure stratifiée comprenant une feuille métallique (11), une plaquette à dissipateur de chaleur noyé (13, 15) et un pré-imprégné (12, 14) pour le raccordement entre les couches ;
plaquer une surface de paroi du trou de raccordement ;
déverser une résine dans le trou de raccordement ;
appliquer un placage formant couvercle pour fermer le trou de raccordement rempli de résigne ;
déposer une seconde carte multicouche (20) sur une surface de la première carte multicouche (10) ;
former un trou de passage passant de la première carte multicouche (10) à la seconde carte multicouche (20) dans une position telle que le trou de passage est entouré par une partie plaquée de la surface de paroi ; et
retirer la résine déversée.

2. Procédé selon la revendication 1, **caractérisé en ce que** :
le trou de raccordement est un trou unique ; et
le trou de passage est plus petit que le trou de raccordement.

3. Procédé selon la revendication 1, **caractérisé en ce que** :
le trou de raccordement est une pluralité de trous,
les trous recouvrent une partie du trou de passage, et sont positionnés dans une position telle qu'une partie ne recouvrant pas le trou de passage d'une surface de paroi de chacun des trous fait partie d'une surface de paroi du trou de passage, et
le trou de passage est formé pour retirer une partie de chacun des trous recouvrant le trou de passage.
